# EUROPEAN PATENT APPLICATION

(11) **EP 3 503 397 A1**
(43) Date of publication of application: **26.06.2019**
(21) Application number: 17208766.0
(22) Date of filing: 20.12.2017
(51) Int. Cl.: H03K 17/16, H03K 17/042, H02M 1/08

(54) **DRIVER UNIT, ELECTRIC POWER CONVERTER, VEHICLE AND METHOD FOR OPERATING AN ELECTRIC POWER CONVERTER**

(71) Applicant: Valeo Siemens eAutomotive Germany GmbH, 91056 Erlangen (DE)
(72) Inventor: HUBNER, Philip, 91052 Erlangen (DE); EDELHÄUSER, Rainer, 90411 Nürnberg (DE)
(74) Representative: Dr. Gassner & Partner mbB

(57) **Abstract**

Driver unit (4) for a voltage-controlled switching element (7) for an electric power converter (1), comprising an output (14) for connecting the driver unit (4) to a control terminal (12) of the switching element (7), an input (15) for obtaining control information and a driving section (16) configured to provide a current (17) to the output (14), wherein based on a first control information indicative for switching the switching element (7) the current (17) charges or discharges a capacitance of the control terminal (12), characterized in that the driving section (16) comprises at least one controllable current source circuit (29a, 29b) configured to provide the current (17) with a value based on a second control information representative for a switching speed of the switching element (7).

## Description

The present invention relates to a driver unit for a voltage-controlled switching element for an electric power converter, comprising an output for connecting the driver unit to a control terminal of the switching element, an input for obtaining control information and a driving section configured to provide a current to the output, wherein based on a first control information indicative for switching the switching element the current charges or discharges a capacitance of a control terminal. Aside, the invention relates to an electric power converter, a vehicle and a method for operating an electric power converter.

Driver units are commonly used for switching a voltage-controlled switching element of an electric power converter, such as an inverter. A driving section amplifies a low-power first control information indicative for switching the switching element, e.g. according to pulse-width-modulated switching pattern, obtained from a control unit of the electric power converter at an input of the driver unit. The driving section provides a current to charge and discharge a capacitance of the control terminal of the switching element connected to an output of the driver unit. Therein, the switching speed of the switching element depends on the provided current. Particularly with respect to switching off the switching element, a high switching speed allows low switching losses but causes high overvoltages due to parasitic inductances. Correspondingly, high overvoltages are avoided by choosing a low switching speed at the cost of higher switching losses.

For realizing a variable switching speed, it has been proposed to use resistors with different resistances, via which the control terminal is alternatively charged or discharged. Therein, using a resistor with a high resistance causes a lower current and a lower switching speed, whereas using a resistor with the low resistance causes a higher current and a higher switching speed. However, by means of such a driving section the switching speed may be adjusted only stepwisely corresponding to the number of resistors provided. Consequently, the resolution of selectable switching speeds is rather low.

Thus, it is an object of the invention to provide a driver unit with an improved resolution of the switching speed.

According to the invention, the above object is solved by a driver unit as initially described, wherein the driving section comprises at least one controllable current source circuit configured to provide the current with a value based on a second control information representative for a switching speed of the switching element.

The invention is based upon the consideration to provide the current, which charges or discharges, respectively, the control terminal, by the current source circuit. The current source circuit is controllable based on the second control information obtained at the input of the driver unit. In other words, the first control information controls when the current is flowing, whereas the second controls information controls the current's intensity. Advantageously, the switching speed, which corresponds to the value of the current, can be adjusted with a high resolution.

Typically, the switching element is a power transistor, e.g. an insulated gate field-effect transistor such as a metal oxide semiconductor field-effect transistor or an insulated gate bipolar transistor. Thus, the control terminal may correspond to a gate terminal of the power transistor. The capacitance of the control terminal may be a gate capacitance. Preferably, the current source circuit is voltage-controlled. The current source circuit may be formed by a suitable circuit, i.e. comprising a transistor or an operational amplifier, which is configured to control the current flowing therethrough to a value depending on the second control information. The output may comprise a first port connected or connectable to the control terminal and a second port connected or connectable to a terminal of a switching path of the switching element, e.g. to a source terminal or an emitter terminal. The value of the current may also be considered as current strength, current intensity or amperage. Exemplarily, the first control information is provided by a control signal having two levels, wherein one signal level indicates switching off the switching element and another signal level indicates switching on the switching element. Switching off the switching element may refer to transferring the switching element from a conducting switching state to a blocking switching state and switching on the switching element may refer to transferring the switching element from the blocking switching state to the conducting switching state. Typically, the signal levels correspond to a, particularly pulse-width-modulated, switching pattern, which may be provided by a control unit of the electric power converter connected or connectable to the input of the driver unit. The second information may comprise an information representative for a switching off speed of the switching element and/or an information representative for a switching on speed of the switching element.

According to a preferred embodiment of the inventive driver unit, one current source circuit is interconnected to provide the current for discharging the capacitance of the control terminal, if the first control information is indicative for switching off the switching element. Upon receiving the first control information indicative for switching off the switching element the current source circuit may be controlled to pull the current from the control terminal of the switching element or the output of the driver unit, respectively. Particularly, the current source circuit is controllable to provide the current for discharging the capacitance of the control terminal based on the information representative for the switching off speed of the second control information.

Therein, the driving section may comprise a constant voltage source configured to provide the current for charging the capacitance of the control terminal to the output, wherein the driving section may be configured to connect the constant voltage source to the output, if the first control information is indicative for switching on the switching element. Thus, while for switching off the switching element the current source circuit is used, switching on the switching element is performed conventionally by the constant voltage source. The driving section may comprise a resistive element, via which the voltage of the constant voltage source is provided to the output. Thus, the switching speed depends on a time constant being the product of the resistance of the resistive element and the capacitance of the control terminal. The resistive element may have a variable resistance depending on the information representative for the switching on speed of the second control information.

With respect to the inventive driver unit, one current source circuit may be interconnected to provide the current for charging the capacitance of the control terminal, if the first control information is indicative for switching on the switching element. Upon receiving the first control information indicative for switching on the switching element the current source circuit may be controlled to push the current to the output of the driver unit. Particularly, the current source circuit is controllable to provide the current for charging the capacitance of the control terminal based on the information representative for the switching on speed of the second control information.

Therein, the driving section may comprise a resistive element for discharging the capacitance of the control terminal and may be configured to connect the resistive element to the output, if the first control information is indicative for switching off the switching element. Thus, while for switching on the switching element the current source circuit is used, switching off the switching element is performed conventionally by means of the resistive element. Thus, the switching off speed depends on a time constant being the product of the resistance of the resistive element and the capacitance of the control terminal. The resistive element may have a variable resistance depending on the information representative for the switching off speed of the second control information.

Of course, the driving section may comprise the current source circuit for charging the capacitance of the control terminal as well as the current source circuit for discharging the capacitance of the control terminal.

Moreover, it is preferred that the current source circuit is configured to provide the current with a minimum absolute value independent of the second control information. Thereby, it is assured that the capacitance of the control terminal is charged or discharged, respectively, even in the case where the second control information is not provided to the input, e.g. due to an error of the control unit of the electric power converter. Then switching the switching element is still possible with a safe low speed although power losses may not be optimal.

Preferably, the driving section is configured to connect and disconnect the current source circuit to the output based on the first control information. For this purpose, the driving section may comprise a switch for each current source circuit connected in series to the current source circuit, wherein the switch is controllable based on the first control information. Alternatively or additionally, the driving section may be configured to control the current source circuit to provide no current based on the first control information. In other words, if the first control information it is indicative for switching off the switching element, the current source circuit for switching on the switching element is controlled to provide a zero current, and/or if the first control information is indicative for switching on the switching element, the current source circuit for switching off the switching element is controlled to provide a zero current.

In order to improve the electric safety of the driver unit and/or to cope with a high voltage to switch by the switching element, the driver unit may comprise an insulation section configured to decouple the input on the one hand and the driving section and the output on the other hand galvanically. The insulation section may comprise one or more insulation elements, such as an optocoupler, an inductive insulation element or a capacitive insulation element, for transmitting the control information from the input to the driving section. Particularly, one insulation element is provided for transmitting the first control information and/or one insulation element is provided for transmitting the information representative for the switching off speed of the switching element of the second switching information and/or one insulation element is provided for transmitting the information representative for the switching on speed of the switching element of the second switching information.

Preferably, the driving section comprises a conversion section configured to convert digital signals representative for the second information into analog signals for controlling the at least one current source circuit. This is especially advantageous in combination with the above-mentioned insulation section since a digital signal can be transmitted very conveniently, particularly without loss of information, over the insulation section. The conversion section may comprise a low-pass filter for converting the digital signals, particularly representing the switching speed by pulse-width-modulation or by pulse-frequency-modulation, into the analog signals. Alternatively, the conversion section may comprise a digital-analog-converter for converting the digital signals, particularly representing the switching speed by a code, into the analog signals. Preferably, one low-pass filter or one digital-analog-converter is provided for each information of the second control information.

Moreover, the driver unit may be implemented in a single electric component, particularly in an integrated circuit. Thus, the driver unit can be provided to different types of electric power converters, which decreases manufacturing effort, particularly with respect to mass production. The single electric component may comprise a housing covering the whole driver unit.

Furthermore, the present invention relates to an electric power converter, comprising a driver unit according to the invention, and a control unit configured to provide the control information to the input of the driver unit. The switching element may be configured to switch the voltage to be converted by the electric power converter. The control unit may be configured to determine the second control information based on a voltage of a DC link of the electric power converter and/or a temperature of the switching element. Typically, the electric power converter comprises a plurality of switching elements and a plurality of driver units each connected to one switching element.

Preferably, the electric power converter is an inverter.

Furthermore, the present invention relates to a vehicle, comprising an electric machine for driving the vehicle and an electric power converter according to the invention configured to supply the electric machine.

Finally, the present invention relates to a method for operating an electric power converter, comprising a voltage-controlled switching element, and a driver unit, wherein the driver unit obtains control information and provides a current to the switching element, wherein based on a first control information indicative for switching the switching element the current charges or discharges a capacitance of the control terminal, wherein at least one current source circuit provides the current with a value based on a second control information representative for a switching speed of the switching element.

All statements referring to the inventive driver unit apply analogously to the inventive electric power converter, the inventive vehicle and the inventive method, so that the above-mentioned advantages of the inventive driver unit may be achieved as well.

Further details and advantages of the invention are disclosed in the following, wherein reference is made to the schematic drawings showing:
- Fig. 1: a block diagram of a first embodiment of an electric power converter according to the invention;
- Fig. 2: a block diagram of a driver unit of a second embodiment of the electric power converter;
- Fig. 3: a block diagram of a driver unit of a third embodiment of the electric power converter;
- Fig. 4: a block diagram of a driver unit of a fourth embodiment of the electric power converter;
- Fig. 5: a diagram of an embodiment of a vehicle according to the invention.

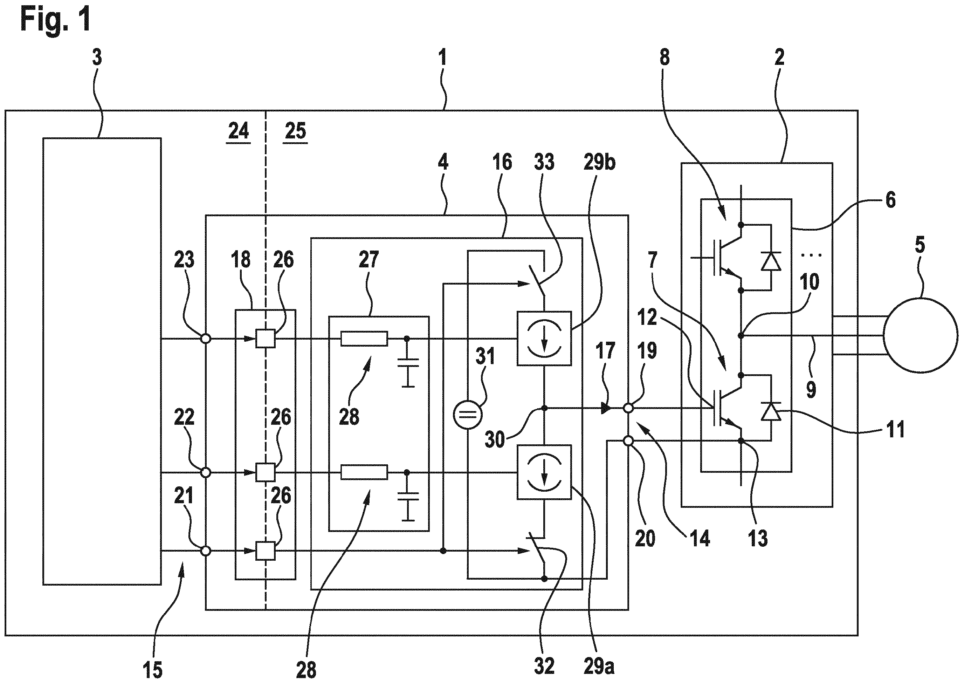

Fig. 1 is a block diagram of the first embodiment of an electric power converter 1, comprising a power unit 2, control unit 3 and driver units 4.

Exemplarily, the electric power converter 1 is depicted as an inverter configured to convert a DC voltage provided to the power unit 2 into a three-phase AC current supplying an electric machine 5. Therein, the power unit 2 comprises a plurality of half bridges 6, each comprising two switching elements 7, 8 connected in series, wherein a phase line 9 is connected to a central tap 10 between the switching elements 7, 8. For each phase line 9 one half bridge 6 is provided. For each switching element 7, 8 one driver unit 4 is provided.

The description in the following refers to the switching element 7 and applies analogously to the switching element 8 and those of the other half bridges 6.

The switching element 7 is a power transistor, e.g. an insulated gate bipolar transistor or an insulated gate field-effect transistor, having a freewheeling diode 11 connected in parallel. In the case of the switching element 7 being an insulated gate field-effect transistor the freewheeling diode 11 is realized by a body diode of the transistor. The switching element 7 comprises a control terminal 12 being the gate terminal of the transistor and a terminal 13 being the emitter terminal or the source terminal, respectively, of the transistor.

The control unit 3 is configured to provide control information that controls the switching behavior of the switching element 7. In the present example, the control information is provided such that the AC current is provided to the electric machine 5 for being driven with a desired rotation rate and torque and low switching losses.

The control information comprises a first control information indicative for switching the switching element 7 on and off according to a pulse-width-modulated switching pattern. The second control information represents a switching speed of the switching element 7 and comprises an information representing a switching on speed and an information representing a switching off speed. The second control information is determined by the control unit 3 based on a voltage of a DC link and a temperature of the switching element 7.

The driver unit 4 comprises an output 14 for connecting the driver unit 4 to the switching element 7, and input 15 for obtaining the control information, a driving section 16 configured to provide a current 17 to the output 14 and an insulation section 18. The driver unit 4 is implemented in a single electric component, such as an integrated circuit.

The output 14 comprises a first port 19 connected to the control terminal 12 and a second port 20 connected to the terminal 13. The input 15 comprises a first port 21, second port 22 and the third port 23 each being connected to the control unit 3. The first control information is obtained by the first port 21, the information representing the switching off speed is obtained by the second port 22 and the information representing the switching on speed is obtained by the third port 23. The control information is obtained as a digital signal provided to each port 21, 22, 23. Therein, each information of the second control information is pulse-width-modulated or pulse-frequency-modulated.

The insulation section 18 is configured to decouple the input 15 on the one hand and the driving section 16 and the output 14 on the other hand galvanically. Thus, the driver unit 4 and the whole electric power converter 1 is split up into a primary side 24 forming a low-voltage side of the power converter 1 and a secondary side 25 forming a high-voltage side of the power converter 1. For that, the insulation section 18 comprises an insulating element 26 for each port 21, 22, 23. Each insulating element 26 is e.g. an optocoupler, an inductive insulating element or a capacitive insulating element. The decoupled digital signals carrying the control information are provided to the driving section 16.

The driving section 16 comprises a conversion section 27 configured to convert the digital signals representative for the second control information into analog signals. For this purpose, the conversion section 27 comprises a low-pass filter 28 for each information of the second control information. In the case of the digital signals being pulse-frequency-modulated the conversion section 27 additionally comprises a shaping element (not shown), which shapes uniform pulses of the digital signal before filtering them by means of the low-pass filter 28.

The driving section 16 comprises a first current source circuit 29a and a second current source circuit 29b each being voltage-controlled and configured to provide the current 17 based on the second control information to the output 14. For this purpose, the current source circuits 29a, 29b are connected in series, wherein a central tap 30 is connected to the first port 19 of the output 14. The current source circuits 29a, 29b are supplied by a constant voltage source 31. Between a negative side of the voltage source 31 and the first current source circuit 29a a first switch 32 is interconnected. Between the positive side of the constant voltage source 31 and the second current source circuit 29b a second switch 33 is interconnected.

If the first control information is indicative for switching off the switching element 7, the first switch 32 is closed and the second switch 33 is opened, therein connecting the first current source circuit 29a to the control terminal 12 via the first port 19 of the output 14 and to the terminal 13 via the second port 20 of the output 14. The first current source circuit 29a pulls the current 17 (having a negative value with respect to a direction depicted in Fig. 1) and discharges the capacitance of the control terminal 12. Therein, the absolute value of the current 17 is controlled by the analog signal being provided by the conversion unit 27 and carrying the information representing the switching off speed of the second control information.

If the first control information is indicative for switching on the switching element 7, the first switch 32 is opened and the second switch 33 is closed, therein connecting the second current source circuit 29b to the control terminal 12 via the first port 19 of the output 14 and to the terminal 13 via the second port 20 of the output 14 and the constant voltage source 31. The second current source circuit 29b provides the current 17 (having a positive value with respect to the direction depicted in Fig. 1) and charges the capacitance of the control terminal 12. Therein, the absolute value of the current 17 is controlled by the analog signal being provided by the conversion unit 27 and carrying the information representing the switching on speed of the second control information.

Thus, the current 17 provided for charging or discharging, respectively, the capacitance of the control terminal 12 is substantially proportional to the switching speed represented by the second control information. To prevent a failure of the switching element 7 in the case of the control unit 3 being unable to provide the second information, the current source circuits 29a, 29b are each configured to provide the current 17 with a minimum absolute value independent of the second control information, if the first control information is indicative for providing the current by the respective current source circuit 29a, 29b.

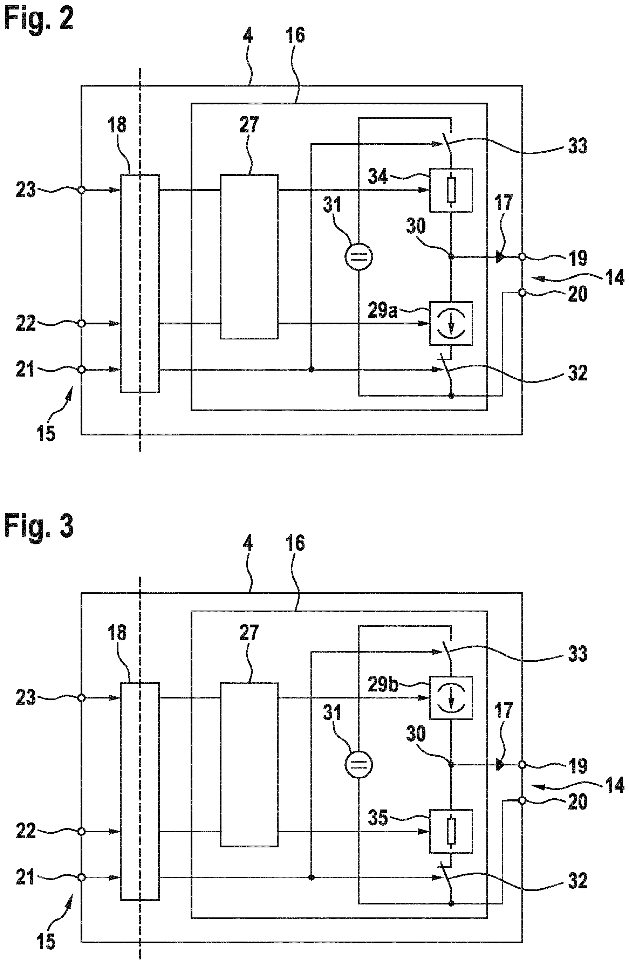

Fig. 2 is a block diagram of a driver unit 4 of a second embodiment of an electric power converter 1, corresponding to the first embodiment. In place of the second current source circuit 29b, the driver unit 4 comprises a resistive element 34 having a variable resistance controllable by the analog signal carrying the information representing the switching on speed of the second control information. Thus, if the first control information is indicative for switching on the switching element 7, the current 17 is provided by the constant voltage source 31 being connected via the second switch 33 and the resistive element 34 to the first port 19 of the output 14. Therein, the capacitance of the control terminal 12 is charged depending on the product of the resistance of the resistive element 34 and the capacitance of the control terminal 12. Alternatively, the resistive element 34 has a fixed resistance, wherein the third port 23, the insulating element 26, the low-pass filter 28 connected to the third port 23 are omitted.

Fig. 3 is a block diagram of a driver unit 4 of a third embodiment of an electric power converter 1, corresponding to the first embodiment. In place of the first current source circuit 29a, the driver unit 4 comprises a resistive element 35 having a variable resistance controllable by the analog signal carrying the information representing the switching off speed according to the second control information. Thus, if the first control information is indicative for switching off the switching element 7, the current 17 is provided to discharge the capacitance of the control terminal 12 via the port 19, the resistive element 35, the first switch 32 being closed and the second port 20 of the output 14. Therein, the capacitance of the control terminal 12 is discharged depending on the product of the resistance of the resistive element 35 and the capacitance of the control terminal 12. Alternatively, the resistive element 35 has a fixed resistance, wherein the second port 22, the insulating element 26, the low-pass filter 28 connected to the second port 22 are omitted.

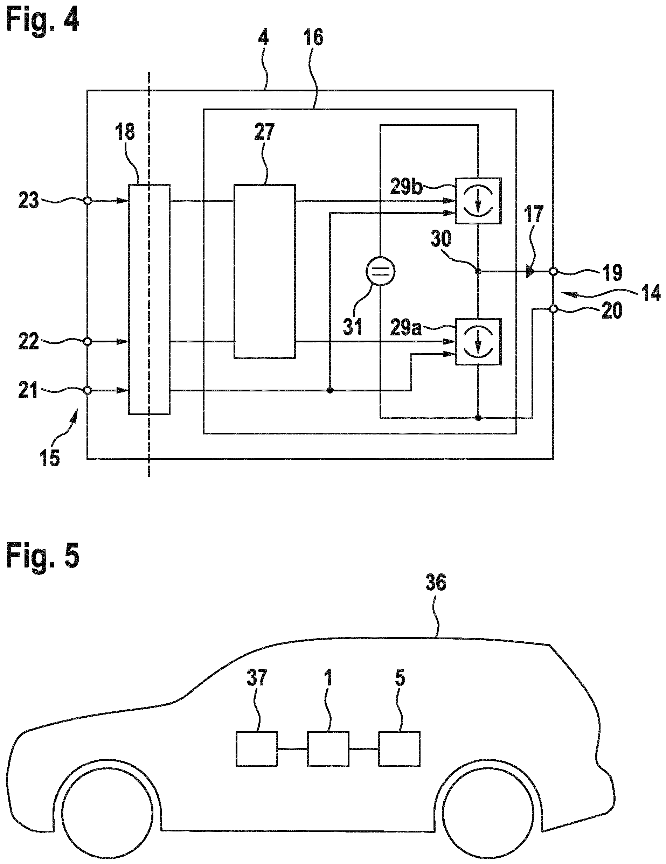

Fig. 4 is a block diagram of a driver unit 4 of a fourth embodiment of an electric power converter 1, corresponding to the first embodiment. In the fourth embodiment the switches 32, 33 are omitted and the driving section 16 is configured to control the current source circuit 29a, 29b to provide no current 17, i.e. a zero current, based on the first control signal. Therein, if the first control signal is indicative for switching off the switching element 7, the second current source circuit 29b provides no current and the first current source circuit 29a provides the current 17 based on the second control information. If the first control signal is indicative for switching on the switching element 7, the first current source circuit 29a provides no current and the second current source circuit 29b provides a current 17 based on the second control information.

With respect to the second and third embodiment the switch 32, 33 connected directly in series to the current source circuit 29a, 29b may be omitted when the corresponding current source circuit is controlled by the first control information to provide no current according to the fourth embodiment.

According to a further embodiment corresponding to any of the aforementioned ones, in place of the low-pass filter 28 a digital-analog-converter it is provided, wherein the digital signals represent the switching speed by a code to be decoded by the digital-analog-converter.

Fig. 5 is a diagram of an embodiment of a vehicle 36, comprising an electric power converter 1 according to any of the aforementioned embodiments, an electric energy source 37, such as a high-voltage battery or a fuel-cell, supplying the power unit 2 of the electric power converter 1 and an electric machine 5 configured to drive the vehicle 36 and supplied by the electric power converter 1.

## Claims

1. Driver unit (4) for a voltage-controlled switching element (7) for an electric power converter (1), comprising an output (14) for connecting the driver unit (4) to a control terminal (12) of the switching element (7), an input (15) for obtaining control information and a driving section (16) configured to provide a current (17) to the output (14), wherein based on a first control information indicative for switching the switching element (7) the current (17) charges or discharges a capacitance of the control terminal (12), **characterized in that** the driving section (16) comprises at least one controllable current source circuit (29a, 29b) configured to provide the current (17) with a value based on a second control information representative for a switching speed of the switching element (7).

2. Diver unit according to claim 1, wherein one current source circuit (29a) is interconnected to provide the current (17) for discharging the capacitance of the control terminal (12), if the first control information is indicative for switching off the switching element (7).

3. Driver unit (4) according to claim 2, wherein the driving section (16) comprises a constant voltage source (31) configured to provide the current (17) for charging the capacitance of the control terminal (12) to the output (14), wherein the driving section (16) is configured to connect the constant voltage source (31) to the output (14), if the first control information is indicative for switching on the switching element (7).

4. Diver unit according to claim 1 or 2, wherein one current source circuit (29b) is interconnected to provide the current (17) for charging the capacitance of the control terminal (12), if the first control information is indicative for switching on the switching element (7).

5. Driver unit (4) according to claim 4, wherein the driving section (16) comprises a resistive element (35) for discharging the capacitance of the control terminal (12) and is configured to connect the resistive element (35) to the output (14), if the first control information is indicative for switching off the switching element (7).

6. Driver unit (4) according to any of the preceding claims, wherein the current source circuit (29a, 29b) is configured to provide the current (17) with a minimum absolute value independent of the second control information.

7. Driver unit (4) according to any of the preceding claims, wherein the driving section (16) is configured to connect and disconnect the current source circuit (29a, 29b) to the output (14) based on the first control information and/or to control the current source circuit (29a, 29b) to provide no current based on the first control information.

8. Driver unit (4) according to any of the preceding claims, wherein the driver unit (4) comprises an insulation section (18) configured to decouple the input (15) on the one hand and the driving section (16) and the output (14) on the other hand galvanically.

9. Driver unit (4) according to any of the preceding claims, wherein the driving section (16) comprises a conversion section (27) configured to convert digital signals representative for the second information into analog signals for controlling the at least one current source circuit (29a, 29b).

10. Driver unit (4) according to claim 9, wherein the conversion section (27) comprises a low-pass filter (28) for converting the digital signals, particularly representing the switching speed by pulse-width-modulation or by pulse-frequency-modulation, into the analog signals, or wherein the conversion section (27) comprises a digital-analog-converter for converting the digital signals, particularly representing the switching speed by a code, into the analog signals.

11. Driver unit (4) according to any of the preceding claims, wherein the driver unit (4) is implemented in a single electric component, particularly in an integrated circuit.

12. Electric power converter (1), comprising a driver unit (4) according to any of claims 1 to 11, and a control unit (3) configured to provide the control information to the input (15) of the driver unit (4).

13. Electric power converter (1) according to claim 12, wherein the electric power converter (1) is an inverter.

14. Vehicle (36), comprising an electric machine (5) for driving the vehicle (36) and an electric power converter (1) according to claim 12 or 13 configured to supply the electric machine (5).

15. Method for operating an electric power converter (1), comprising a voltage-controlled switching element (7) and a driver unit (4), wherein the driver unit (4) obtains control information and provides a current (17) to the switching element (7), wherein based on a first control information indicative for switching the switching element (7) the current (17) charges or discharges a capacitance of the control terminal (12), wherein at least one current source circuit (29a, 29b) provides the current (17) with a value based on a second control information representative for a switching speed of the switching element (7).
